# EUROPEAN PATENT SPECIFICATION

(11) **EP 1 318 643 B1**
(45) Date of publication and mention of the grant of the patent: **02.05.2007**
(21) Application number: 01128934.5
(22) Date of filing: 05.12.2001
(51) Int. Cl.: H04L 27/36

(54) **Method and device for performing adaptive predistortion**
Verfahren und Vorrichtung zur Durchführung einer adaptiven Vorverzerrung
Procédé et dispositif pour realiser de prédistortion adaptative

(43) Date of publication of application: 11.06.2003
(73) Proprietor: TELEFONAKTIEBOLAGET LM ERICSSON (publ), 164 83 Stockholm (SE)
(72) Inventor: Kehlenbach, Werner, 90491 Nürnberg (DE); Hamrin, Stefan, 187 65 Täby (SE); Leyonhjelm, Scott, 172 34 Sundbyberg (SE); Dalipi, Spendim, 191 42 Sollentuna (SE); Klingberg, Mats, 122 66 Enskede (SE)
(74) Representative: Schmidt, Steffen J.

(56) References cited:
- US-B1- 6 252 912
- US-B1- 6 285 412

## Description

### BACKGROUND OF THE INVENTION

### Technical Field

The invention relates to a method of performing adaptive predistortion and to a transmitter stage employing this method. In particular, the invention relates to performing adaptive predistortion to compensate nonlinearities of an amplifier which produces from an input radio signal an amplified radio signal.

### Description of the Prior Art

Wireless communications systems are increasingly making use of radio modulations with nonconstant envelope, i.e., fluctuating signal amplitudes. Such radio modulations like quadrature phase shift keying modulations (QPSK, OQPSK or II/4-QPSK) or quadrature amplitude modulations (n-QAN) help to improve the spectral efficiency of the communications system. This means that, for a given data rate, these radio modulations have the advantage of requiring a smaller frequency bandwidth than conventional radio modulations like gaussian minimum shift keying modulation (GMSK) with constant envelope. The downside of this advantage is that modulation techniques with nonconstant envelope require a very linear transmission system in order to avoid spectral broadening resulting from nonlinearities.

Regarding the spectral broadening, the critical point is usually the power amplifier of the transmitter stage. High signal peaks, which are common for modulation techniques with nonconstant envelope, let the power amplifiers momentarily run very close to saturation which results in significant intermodulation distortion and significant power emissions in adjacent channels. So far a solution has been to run power amplifiers with enough back-off to prevent even high signal peaks from causing nonlinear distortion and out-of-band emissions. This approach, however, is expensive and causes size and heat dissipation problems.

According to an alternative approach, various linearization techniques have been proposed which allow power amplifiers to run closer to their saturation point while keeping power emissions in adjacent channels low. One implementation of these linearization techniques uses adaptive predistortion.

Such an adaptive predistortion scheme is described in US 5,905,760. The predistortion scheme consists in applying a predistortion table to a baseband signal in order to generate a predistorted baseband signal. The predistortion table comprises a set of predistortion data which is calculated in the digital domain by comparing the baseband signal with a demodulated signal derived from an amplified output radio signal of the power amplifier. According to the adaptive aspect of the predistortion, the comparison is performed during several adaptation periods in order to update the predistortion table.

A similar adaptive predistortion scheme is disclosed in US 6,285,421.

The ideal solution would be to perform such a comparison for every sample which is to be sent. However, the calculations required for this comparison can often not be performed in real-time due to computational constrains. For example, departing from a chip rate of 3.84 Msps and four times oversampling, a typical data rate for a wideband code division multiple access (WCDMA) system would be 15.36 Msps. Consequently, each processing cycle could take a maximum of 1/15.36 Msps or 65.1 ns. This is beyond the computational capabilities of most of today's hardware.

On the other hand, processing of all samples is not necessarily required because the adaptive nature of the predistortion usually only has to keep track of slow processes like temperature changes, aging of the power amplifier, etc. Therefore, generation of an adapted set of predistortion data can be performed off-line by means of an appropriate adaptation technique on the basis of samples which are comprised within the demodulated signal of the power amplifier and which were collected earlier.

US 5,524,286 relates to a table based predistortion technique which modifies the addressing scheme of the tables as a function of the amplitude value of an input sample. The manner in which the amplitude values are mapped onto a set of addresses is nonlinear and causes a non uniform quantization. The quantization intervals each have an amplitude value which is inversely proportional to the probability that the amplitude of the input sample will fall in said interval. In this manner the probability that the amplitude of the input sample falls within a predetermined interval is on the average the same for all intervals. Thus, the number of samples used to provide adapted table parameters is the same for all table entries.

One object of the present invention is to improve convergence speed of the adaptation technique used for generating a set of predistortion data.

### SUMMARY OF THE INVENTION

According to the invention this object is satisfied by a method of performing adaptive predistortion to compensate nonlinearities of an amplifier which produces from an input radio signal generated from a first sample stream an amplified radio signal, the method comprising generating a second sample stream from the amplified radio signal, selectively collecting samples comprised within the second sample stream such that the statistical properties of the collected samples differ from the average statistical properties of the second sample stream, creating adapted predistortion data based on a comparison of the samples collected from the second sample stream with the corresponding samples from the first sample stream, and performing predistortion using the adapted predistortion data to produce a predistorted third sample stream. Predistortion can be performed in the digital domain, in the analog domain or partly in the digital and partly in the analog domain.

According to one aspect of the invention, the samples from at least the second sample stream, i.e., at least the samples derived from the amplified output radio signal of the power amplifier, are collected or captured continuously and preferably also during generation of the adapted predistortion data. Optionally, samples from the first sample stream or the third sample stream or from both the first and the third sample stream could be collected as well.

The continuous collection of samples from at least the second sample stream, however, does not mean that actually all samples comprised within a particular sample stream are collected. Instead, a selective collection takes place. This selective collection is preferably performed such that the collected samples have specific statistical properties, which for example deviate from the average statistical properties of the second sample stream in a predetermined direction or meet one or more specific statistical constraints. The statistical constraints can be static and predefined or can be adapted dynamically. Those samples of for example the second sample stream which cause that the collected samples will not or no longer satisfy the specific statistical properties may not be collected and may be discarded. By generating the adapted predistortion data on the basis of collected samples with desired statistical properties, convergence speed of the adaptation scheme is improved.

The statistical properties which are to be satisfied by the collected samples can relate to various aspects of the collected samples. Preferably, the statistical properties relate to an amplitude or power probability distribution. The following references to signal amplitudes or amplitude-related parameters like the amplitude probability distribution also apply to the signal power or the respective power-related parameters.

As a result of the statistical constraint the amplitude probability distribution of the collected samples may be raised at least locally compared to an average amplitude probability distribution of all samples comprised within the second sample stream. Such statistical properties are given when the collected samples comprise more samples of specific amplitude values or of specific ranges of amplitude values than statistically comprised within the second sample stream.

The amplitude probability distribution of the collected samples is raised preferably at least for amplitude values of an upper amplitude range, e.g. above an amplitude threshold, compared with the average amplitude probability distribution of the second sample stream. The amplitude threshold can be a specific amplitude value which is initially defined or an amplitude value which is dynamically shifted. The raising of the amplitude probability distribution in an upper amplitude range may be performed by selectively collecting more samples with an large amplitude than samples with a low amplitude.

By raising the amplitude probability distribution at least locally, one or more specific amplitude values or one or more specific ranges of amplitude values among the collected samples, which are used for generating the adapted predistortion data, are weighted stronger. Especially preferred is a stronger weighting of the rare signal peaks that drive the power amplifier close to saturation because these signal peaks are most to blame for out-of-band emissions and emissions in adjacent channels.

There exist various possibilities how the samples can be selectively collected and processed. The samples may be collected individually, i.e., picked on a sample-by-sample basis, or in the form of one or more sample sequences. Furthermore, the sample collection may be a combination of both possibilities. According to a preferred variant of the invention the adapted predistortion data are created based on a plurality of sample sequences.

Regardless whether the samples are collected in the form of individual samples or in the form of one or more sample sequences, an assessment may be implemented to determine if a specific sample or a sample sequence comprising a specific sample has to be collected or not. The assessment may be performed on the basis of either one of or a combination of the first, the second and the third sample stream.

An assessment step is preferably performed for each sample comprised within a particular sample stream. For example, the assessment may be performed for each sample comprised within the second sample stream by evaluating either this sample or a corresponding sample of the first or third sample stream. Alternatively, the assessment may be performed in intervals in the form of spot checks. In the case of spot checks the interval between two consecutive checks, i.e., the number of samples between a first spot check and a consecutive second spot check, is preferably chosen such that the probability that characteristic signal phenomena like signal maxima (peaks) or signal minima are missed is minimized.

If the samples are collected in the form of one or more sample sequences each collected sample sequence is preferably selected such that it captures one or more signal peaks. Thus the amplitude probability distribution of the collected samples is raised in an upper amplitude range. The signal peaks can be identified by a threshold decision which can be based on a fixed or a variable threshold value.

In the case of a variable threshold value, a variation of the variable threshold value can be controlled in dependence of one or more parameters like time, a previous threshold value, and a current signal peak. For example, if no signal peak is detected within a predetermined period of time, the currently valid threshold value may be decreased. On the other hand, a currently valid threshold value may be increased if for example a newly detected signal peak is higher than the highest signal peak previously captured. Various modifications of these control mechanisms are possible.

Preferably, the samples are selectively collected and processed in sample blocks which may have predefined block sizes. A sample block may be divided into individual sample bins for structuring the selectively collected samples. Each sample bin can be reserved for selectively collected samples having specific properties. For example, if the statistical constraint which has to be satisfied by the collected samples relates to the amplitude probability distribution of the collected samples, each sample bin may be reserved for samples having an amplitude within a particular amplitude range.

The sample bins can have all the same nominal bin size or may have individual nominal bin sizes. For example, the sample bins may be spaced with equidistance or logarithmically. According to a preferred variant of the invention, the nominal bin sizes are chosen such that the sizes represent specific properties of the collected samples.

According to a possible implementation of the invention, the predistortion data are adapted on a block-by-block basis. This means that if generation of a first set of adapted predistortion data based on a previous sample block is completed, a newly collected sample block is used for generating a second, updated set of adapted predistortion data. It has to be noted that according to the preferred aspect of a continuous collection the selective collection of samples is not interrupted during the procedure of generating a new set of adapted predistortion data.

Preferably, the collection of samples becomes selective only after enough samples required to generate a single set of adapted predistortion data have been collected. This means for example that if the number of samples collected in a sample block does not yet equal a predefined sample block size, a newly assessed sample is collected individually or in the form of a sample sequence in the sample bin reserved for this particular sample or sample sequence even if the sample or sample sequence does not meet a desired statistical constraint or even if the nominal bin size is exceeded. Once enough samples for generating an adapted set of predistortion data has been collected, i.e., once the number of samples in the sample block equals or exceeds the predefined sample block size, the selection mechanism may be activated.

The selection mechanism is preferably implemented such that a sample comprised within a particular sample stream (for example within the second sample stream) is not collected but discarded if the sample bin reserved for the sample has reached its nominal bin size or if all sample bins are occupied. Otherwise, i.e., if e.g. the sample bin reserved for this sample has not yet reached its nominal bin size, the sample may be collected in this sample bin. In the case the sample is collected individually in the corresponding sample bin, the sample block contains more samples than actually needed for generating an adapted set of predistortion data. Consequently, a sample collected earlier may be deleted. This deletion is preferably performed such that a sample collected in that sample bin which exceeds its nominal bin size most is discarded.

As has become apparent from the above, the samples are usually no longer indiscriminately collected in the form of a single continuous sample sequence comprised within a particular sample stream but in the form of selected individual samples or selected sequences of samples. This somewhat complicates the comparison of the collected samples from the second sample stream with the corresponding samples from the first sample stream during generation of the predistortion data. Consequently, the step of generating predistortion data may comprise an aligning of each individually collected sample or each individually collected sample sequence with the corresponding sample or sample sequence from the first sample stream.

The above method can be implemented both as a hardware solution and as a computer program product comprising program code portions for performing the method when the computer program product is run on a computer. The computer program product may be stored an a computer-readable recording medium like a data carrier attached to or removable from the computer.

The hardware solution mentioned above may be constituted by a transmitter stage comprising an amplifier which produces an amplified radio signal from an input radio signal generated from a first sample stream, a feedback unit for generating a second sample stream from the amplified radio signal, a unit for selectively collecting samples from the second sample stream such that the statistical properties of the collected samples differ from the average statistical properties of the second sample stream, a parameter adaptor for creating adapted predistortion data based on a comparison of the collected samples from the second sample stream with the corresponding samples from the first sample stream, and a data modifier for performing predistortion using the adapted predistortion data. The data modifier may be configured and/or programmed to perform the method outlined above. Preferably, the transmitter stage is part of a wireless communications system.

### BRIEF DESCRIPTION OF THE DRAWINGS

Further advantages of the invention will become apparent upon reference to the following description of preferred embodiments of the invention in the light of the accompanying drawings, in which:
- Figs. 1a to 1c: show schematic views of a transmitter stage and of components thereof employing the method according to the invention of performing adaptive predistortion;
- Fig. 2: shows a cumulative density function representing the typical amplitude probability distribution of a WCDMA signal;
- Fig. 3: shows a cumulative density function for a sample block comprising samples selectively collected in accordance with a first embodiment of the invention;
- Fig. 4: shows the division of a single sample block in sample bins of individual nominal bin size according to the first embodiment;
- Fig. 5: shows a flow chart of the collection mechanism implemented for performing adaptive predistortion in accordance with the first embodiment;
- Fig. 6: shows the division of a single sample bock in sample bins of identical nominal bin size according to a second embodiment of the invention;
- Fig. 7: shows a flow chart of a first collection mechanism implemented for performing adaptive predistortion in accordance with a second embodiment;
- Fig. 8: shows a flow chart of a second collection mechanism implemented for performing adaptive predistortion in accordance with a second embodiment;
- Fig. 9: shows a flow chart of a third collection mechanism implemented for performing adaptive predistortion in accordance with a second embodiment.

### DESCRIPTION OF PREFERRED EMBODIMENTS

Although the present invention can be practiced in any communications system requiring adaptive predistortion to compensate nonlinearities of an amplifier which produces an amplified radio signal from an input radio signal generated from a stream of samples, the following description of preferred embodiments is examplarily set forth with respect to a third generation mobile communications system like the system standardized in accordance with the third generation partnership project (3GPP).

In Fig. 1a a transmitter stage 10 of a transceiver of such a third generation mobile communications system is schematically depicted. The transmitter stage 10 comprises a digital signal source 12 which produces from binary user data a complex-valued signal in the form of an in-phase component Iᵢ and an quadrature component Qᵢ at a sampling frequency fₛ. The complex-valued signal output by the signal source 12 has a nonconstant envelope.

The components Iᵢ and Qᵢ of the complex-valued signal represent ideal samples and are input into a baseband processing unit 14. In the baseband processing unit 14, the components Iᵢ and Qᵢ are shaped by one or more filters to produce a baseband signal having a spectrum confined to a specific bandwidth. The output signal of the baseband processing unit 14 is input as a stream of samples into a digital predistortion unit 16 which applies a predistortion technique to the signal received from the baseband processing unit 14 to produce a stream of predistorted samples I_{d} and Q_{d}.

It should be noted that the digital predistortion unit 16 could also be arranged prior to the baseband processing unit 14, such that it acts on the binary user data, at a digital intermediate frequency or immediately prior to the power amplifier 22, such that the data modifier is a combined analog or digital solution. Also, the frequency up and down conversion processes could be split between the analog and digital domains.

The predistorted signal I_{d}, Q_{d} output by the digital predistortion unit 16 of Fig. 1a is converted into analog form by a digital/analog converter 18 and than fed to a radio frequency converter 20 which delivers an input radio signal for a power amplifier 22. The power amplifier 22 amplifies the input radio signal to produce an amplified radio signal which is fed to an antenna 24 of the transmitter stage 10.

A coupler 25 samples a fraction of the amplified radio signal at an output of the power amplifier 22. This fraction is fed to a feedback unit 26 for generating a stream of real samples from the amplified radio signal. The feedback unit 26 comprises a radio frequency downconverter 28 and an analog/digital converter 30. The radio frequency downconverter 28 demodulates the amplified radio signal and produces a demodulated signal. The demodulated signal output by the radio frequency down converter 28 is fed to the analog/digital converter 30 which digitizes the in-phase and quadrature components of the demodulated signal at the sampling frequency f_{S}. The components Iᵣ and Qᵣ output by the analog/digital converter 30 represent the real samples generated from the amplified radio signal. From the feedback unit 26, a stream of real samples Iᵣ, Qᵣ is fed back to the digital predistortion unit 16.

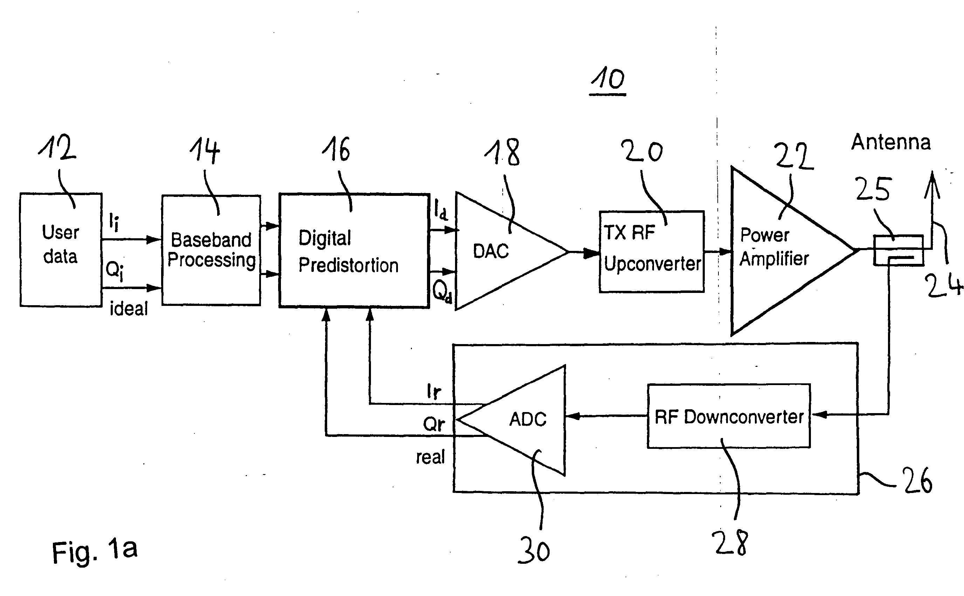

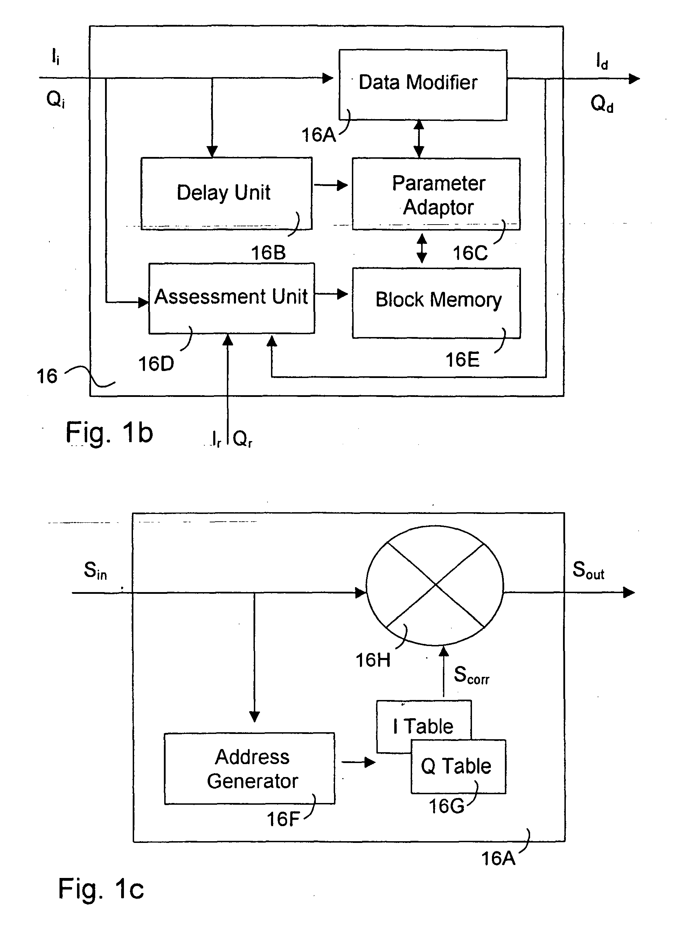

In Fig. 1b the individual components of the digital predistortion unit 16 are shown. Basically, the digital predistortion unit 16 can be divided into five parts, a data modifier 16A, a delay unit 16B, a parameter adaptor 16C, an assessment unit 16D and a block memory 16E.

The stream of input samples Iᵢ, Qᵢ received by the predistortion unit 16 is fed to the data modifier 16A, the delay unit 16B and the assessment unit 16D. The assessment unit 16D further receives the stream of real samples Iᵣ, Qᵣ, and, optionally, the stream of predistorted samples I_{d}, Q_{d}. After having passed the assessment unit 16D, individual samples or sample sequences from the stream of real samples Iᵣ, Qᵣ, and, optionally, of one or more of the further sample streams are stored in the block memory 16E. The assessment unit 16D performs its decisions based on one or more of these three sample streams. In the embodiments described below it is exemplarily assumed that the assessment unit 16D performs its decisions based on the stream of real samples Iᵣ, Qᵣ.

The configuration of the data modifier 16A is depicted in more detail in Fig. 1c. The data modifier 16A shown in Fig. 1c comprises an address generator 16F, two tables 16G and a complex multiplier 16H. The data modifier 16A of the embodiment depicted in Fig. 1c uses the table based predistortion technique of complex gain predistortion. It should be noted that non-table based predistortion techniques like polynomial implementations or other table based predistortion techniques like mapped predistortion or amplitude and sample time predistortion (partly table based) could be used as well.

The data modifier 16A of Fig. 1c receives a complex baseband input digital signal Sᵢₙ in the form of the samples Iᵢ and Qᵢ. The address generator 16F of the data modifier 16A then calculates one or more table addresses in accordance with a predefined function of the instantaneous amplitude of the input digital signal. The predefined function could be any instantaneous function of the signal amplitude or the signal power of Sᵢₙ.

The table address generated for a specific digital sample by the address generator 16F is used to look up in the tables 16G the complementary complex gain S_{corr} of the power amplifier 22 for that digital sample. For example S_{corr} is determined by looking up the table value with the closest table address or by calculating a table value via linear interpolation between two table addresses. In the embodiment depicted in Fig. 1c, the tables 16G contain the total complementary complex gain of the power amplifier 22 such that the combination of the complementary complex gain of the data modifier 16A and the power amplifier 22 results in linear gain and phase for all input signal magnitudes. The complementary complex gain S_{corr} and the input digital Sᵢₙ are processed by the complex multiplier 16H. The output Sₒᵤₜ of the complex multiplier 16F is designed so as to linearize the power amplifier 22.

The data modifier 16A described above only operates on the instantaneous sample. However, introduction of a predistortion scheme which is dependent also on one or more previous samples could be envisaged also. Thus a memory or frequency dependence effect may be implemented. This could be effected for example by introducing an additional address component to the address generated by the instantaneous function of amplitude. The additional address component, which can be thought of as a second table address dimension, may be calculated by a "leaky integrator" which is a low pass (IIR) filter with certain rise and fall times matched to the thermal nature of the amplifier 22. According to an alternative approach, a FIR filter implementation could be used whereby the coefficients of the filter are accessed from a table addressed by a function of the instantaneous amplitude of the signal. The coefficients are then multiplied with a weight generated from a FIR or IIR filter. A third alternative for including a memory or frequency dependency effect is the implementation of frequency equalizers preceding and following the (memoryless) data modifier 16A of Fig. 1b to compensate the amplifier input and output circuits, respectively.

So far the data modifier 16A has been described in more detail. Now the parameter adaptor 16C of Fig. 1b will be considered. The parameter adaptor 16C can be operated in accordance with various parameter adaptation schemes like dithering schemes, linear adaptation schemes, secant adaptation schemes, direct inverse modeling schemes and curve fitting or RLS estimation schemes. All those schemes are known to a person skilled in the art and differ in convergence speed, stability and accuracy. Typically, the parameter adaptor 16C performs parameter adaptation based on the original (ideal) signal, the predistorted signal and an output signal from the power amplifier. Parameter adaptation can be based either on transmitted data, which is the preferred approach, or on special training sequences.

In principle, the feedback unit 26 can be implemented either coherently or non-coherently. The non-coherent feedback implementation comprises an estimation of the spectral components at the output of the power amplifier 22. The coherent feedback implementation, which is used by the transmitter stage 10, is based on an acquisition of a sample stream generated from an output signal of the power amplifier 22 which is coherent in the time domain with a corresponding input signal. To that end, the digital predistortion unit 16 comprises the delay unit 16B depicted in Fig. 1b. The coherent feedback technique is more complex than the non-coherent implementation but is independent of a modulation format or of the number of carriers.

The digital predistortion unit 16 of Fig. 1a continuously but selectively collects real samples Iᵣ, Qᵣ comprised within the stream of real samples received from the feedback 26 unit. As will be explained below, the digital predistortion unit 16 selectively collects the real samples such that the selectively collected real samples have desired statistical probabilities with respect to the amplitude probability distribution of the collected real samples.

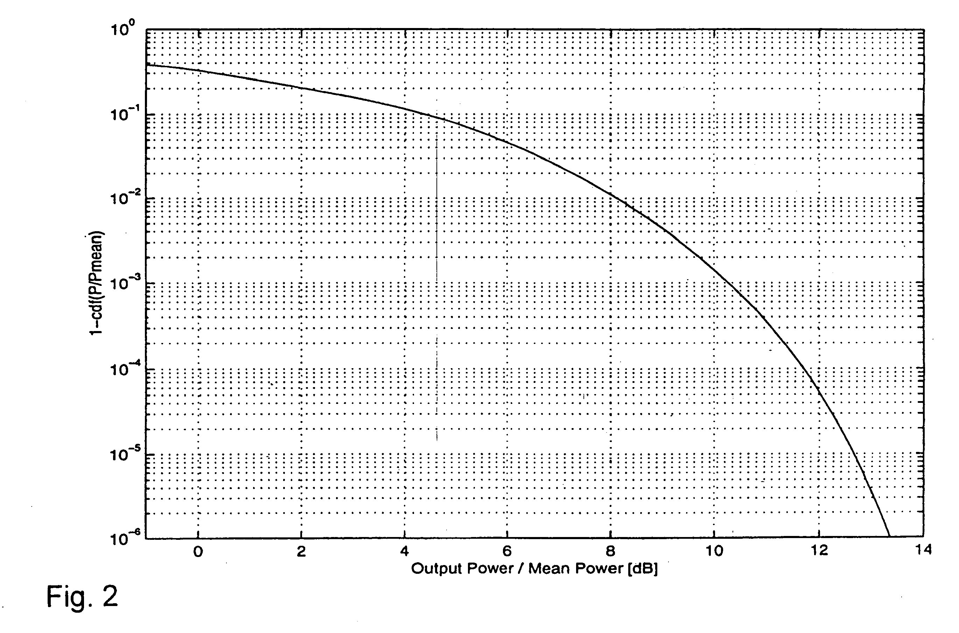

Prior to explaining the selection mechanism performed within the digital predistortion unit 16 in more detail, the problems arising from non selective collecting mechanisms will be explained with reference to Fig. 2. Fig. 2 shows a typical cumulative density function for a WCDMA signal. The cumulative density function of Fig. 2 represents the probability with which a signal amplitude lies above a specific amplitude value. From Fig. 2 it can be seen, for example, that the probability that a signal peak is more than 12dB above mean power equals approximately 5*10⁻⁵. This low probability of the signal peaks comprised within a WCDMA signal is a manifestation of the fact that WCDMA signals typically have highly fluctuating phase and amplitude modulation resulting in rare signal peaks.

Since the signal peaks are rare, not many samples with large amplitude values will be available for creating corresponding adapted predistortion data for updating the predistortion tables 16G of the digital predistortion unit 16. As a result, the values within the predistortion table 16G for which proper predistortion is most important, i.e., the values corresponding to signal peaks which push the power amplifier 22 strongly into its nonlinear operating area, are updated not often enough. This situation is rendered even worse if the real samples used for generating the predistortion data are not collected continuously, i.e., not also during an predistortion data adaptation step, but only prior to start of generating a new set of adapted predistortion data. Such an indiscriminate intermittent collection of real samples increases the probability that the rare real samples with high amplitude values are missed and thus not exploited for the purpose of generating adapted predistortion data.

In order to avoid such a situation, the selective collection of real samples Iᵣ, Qᵣ is performed continuously also during generation of adapted predistortion data, i.e., also during the time the predistortion adaptor 16C is doing its calculations. However, this continuous collection is performed selectively since otherwise the probability distribution of the collected real samples over the signal amplitude would simply reflect the cumulative density function depicted in Fig. 2.

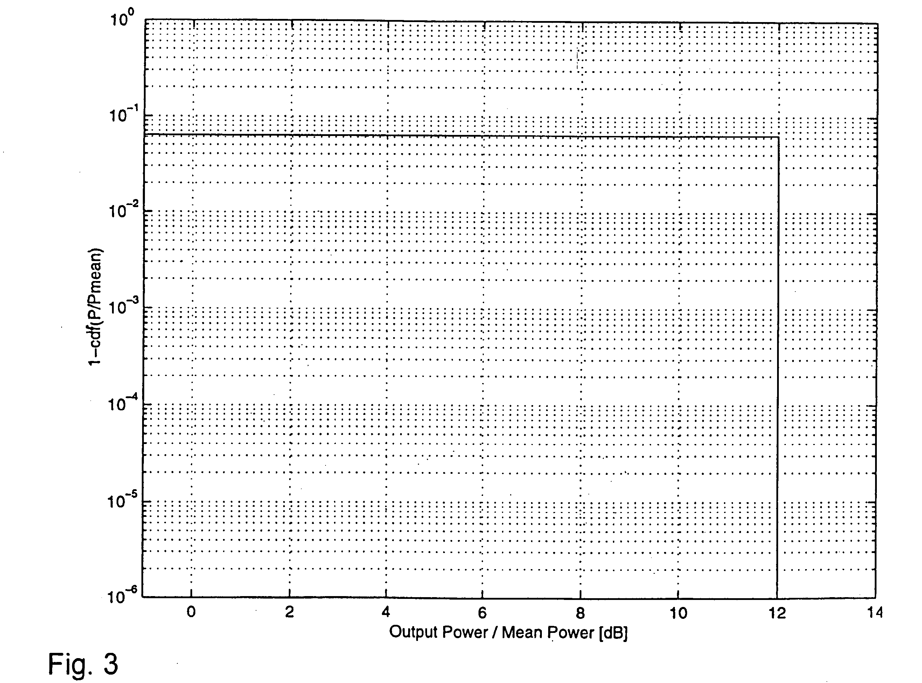

The selective collection of real samples within the digital predistortion unit 16 is performed such that the amplitude probability distribution of the collected real samples is raised locally compared to the average amplitude probability distribution reflected by Fig 2. In particular, according to a first illustrative embodiment of the invention, the real samples are selectively and individually collected such that their amplitude probability distribution becomes constant for all amplitude values above an average amplitude. This situation is depicted in Fig. 3.

Fig. 3 illustrates the cumulative density function of a block of real samples selectively collected and stored in the block memory 16E. From Fig. 3 it can clearly be seen that the amplitude probability distribution of the real samples selectively collected in the sample block over the signal amplitude is flat and not falling off as rapidly as depicted in Fig. 2. Compared to Fig. 2, the amplitude probability distribution is raised for amplitudes above an amplitude threshold of approximately 5dB. Consequently, the critical entries in the predistortion table corresponding to signal amplitudes above 5dB are updated more often, which results in a reduction of the out-of-band emissions generated by the power amplifier 22 shown in Fig. 1.

In the following detailed description of the first embodiment of the invention, an approach for selectively collecting a block of real samples having the probability distribution reflected in Fig. 3 is examplarily described with reference to Figs. 1b, 4 and 5.

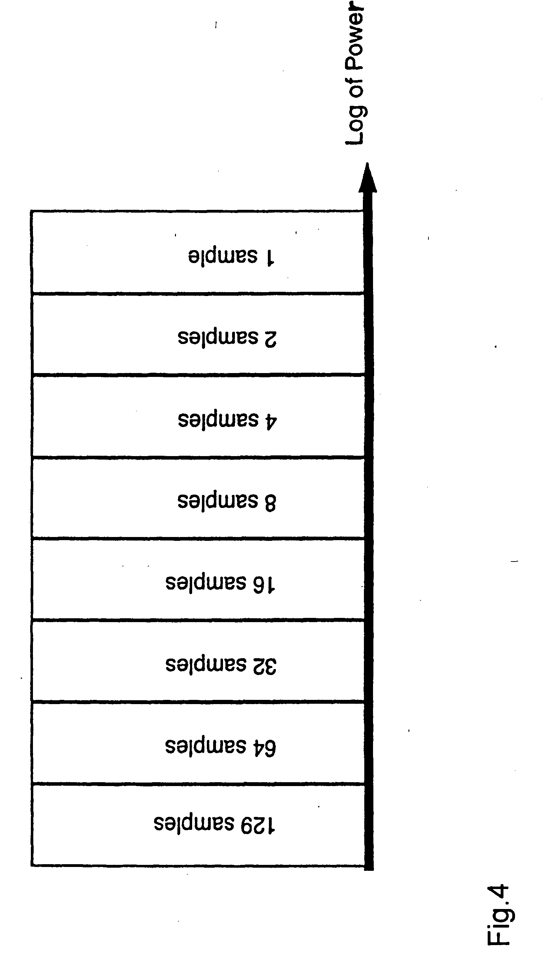

If it is generally assumed that the predistortion scheme operates on for example 256 data points, each sample block to be processed by the parameter adaptor 16C would have a predefined sample block size of 256 samples. Each sample block of 256 real samples is divided into sample bins as depicted in Fig. 4. Each sample bin represents a particular amplitude range. As can be seen from Fig. 4, the individual sample bins are spaced logarithmically. Hence, each sample bin is assigned an individual nominal bin size corresponding to a nominal number of real samples to be stored in the corresponding sample bin. The nominal bin sizes are selected such that a statistical constraint underlying the selection mechanism is reflected. In the present case this means that the nominal bin sizes decrease logarithmically with increasing amplitude. For example the first bin corresponding to the lowest signal amplitude values comprises 129 samples, the second sample bin corresponding to somewhat higher amplitude values comprises 64 samples and so on. The last sample bin corresponding to the highest amplitude values comprises only single sample. Such a bin size distribution reflects the amplitude probability distribution depicted in Fig. 3. Of course, amplitude probability distributions different from the one reflected in Fig. 3 are also possible. In this case the nominal bin size distribution will deviate from the distribution depicted in Fig. 4.

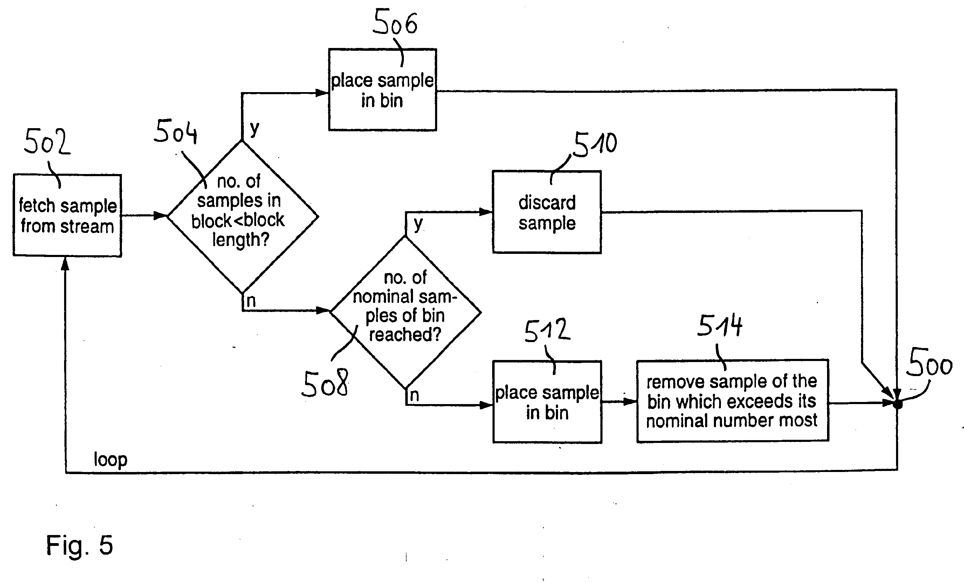

The selective collection mechanism according to the first embodiment of the invention will now be described with reference to the flow chart depicted in Fig. 5.

The mechanism starts at node 500 and, in a first step 502, the assessment unit 16D fetches a single real sample provided by the feedback unit 26 which generates the stream of real samples. In a second step 504 the assessment unit 16D determines whether the number of real samples currently arranged in the sample block stored in the block memory 16E is less than the predefined maximum sample block size of 256 real samples. If the current sample block size is less than the maximum sample block size, the real sample fetched in step 502 is collected in step 506 in the appropriate sample bin of the sample block stored in the block memory 16E. The appropriate sample bin in which the real sample is placed depends on the sample's signal amplitude (see Fig. 3).

From the third step 506 the mechanism returns to node 500 and the first step 502 and the second step 504 are repeated. It should be noted that in the third step 506 the real sample is collected in the appropriate sample bin regardless whether or not the nominal bin size of this sample bin is exeeded. This reflects the fact that in a starting phase of the selective collection mechanism the sample block is filled regardless of the actual amplitude value of a fetched real sample in order to quickly build a sample block which can be processed by the parameter adaptor 16C, i.e., containing 256 real samples.

In the case the assessment unit 16D determines in the second step 504 that the number of samples in the sample block equals the maximum sample block size of 256 real samples, a fourth step 508 is initiated. In the fourth step 508 the assessment unit 16D determines whether or not the appropriate bin which is reserved for the real sample fetched in the first step 502 is filled up to the individual nominal bin size or not. If the number of real samples already arranged in the corresponding sample bin equals the nominal bin size of the sample bin, the newly fetched real sample is discarded in a fifth step 510. From the fifth step 510 the mechanism returns to node 500, from where the collection mechanism loops to the first step 502.

In the case the assessment unit 16D determines in the fourth step 508 that the number of real samples arranged in the sample bin reserved for the real sample fetched in the first step 502 is less then the nominal bin size of this sample bin, the real sample is collected in this sample bin in a sixth step 512. Because the total number of real samples arranged within the sample block now exceeds the predefined maximum sample block size of 256 real samples, one real sample arranged in a different sample bin has to be discarded in a seventh step 514. In the seventh step 514 a real sample is removed from this sample bin, which exceeds its nominal bin size most. Of course, a different removal approach could be implemented as well. For example in the seventh step 514 a real sample of the leftmost sample bin (see Fig. 3) which exceeds its nominal been size could be removed.

In the case the parameter adaptor 16C finishes processing of a previous sample block while one or more sample bins, for example the rightmost sample bin in Fig. 4 of a sample block already comprising 256 samples, are not yet completely filled, processing is started with this incomplete sample block anyway. None of the important rare signal peaks will be lost due to the fact that the selective collection mechanism shown in Fig. 5 will keep on running in parallel with the processing operations of the parameter adaptor 16C.

The method of collecting a data block to be processed by the parameter adaptor 16C described above with reference to Fig. 5 is based on the selective collection individual samples. In other words, the samples are individually assessed and individually placed in the sample bin associated with the sample's amplitude value. In the following, various selective collection mechanisms according to a second embodiment of the invention will be described.

The collection mechanisms of the second embodiment of the invention are not based on an individual sample collection but relate to the selective collection of a plurality of short sequences of samples on the basis of a preceding assessment on a sample-by-sample basis. Collection of short sequences of samples has the advantage over individual sample collection that a certain signal continuity is maintained. Consequently, the parameter adaptor 16C can be configured such that memory or frequency dependency effects are compensated also. Furthermore, the processing efficiency is increased since fractional delay matching performed by the delay unit 16B can take place for a complete sequence of samples. The selective collection of the plurality of short sample sequences is performed such that each sample sequence captures one or more signal peaks as well as neighboring samples. If it is desired to capture the whole peak, i.e., including samples surrounding the peak on both sides, a short delay buffer in communication with the assessment unit 16D may be provided. This delay buffer is not depicted in Fig. 1b.

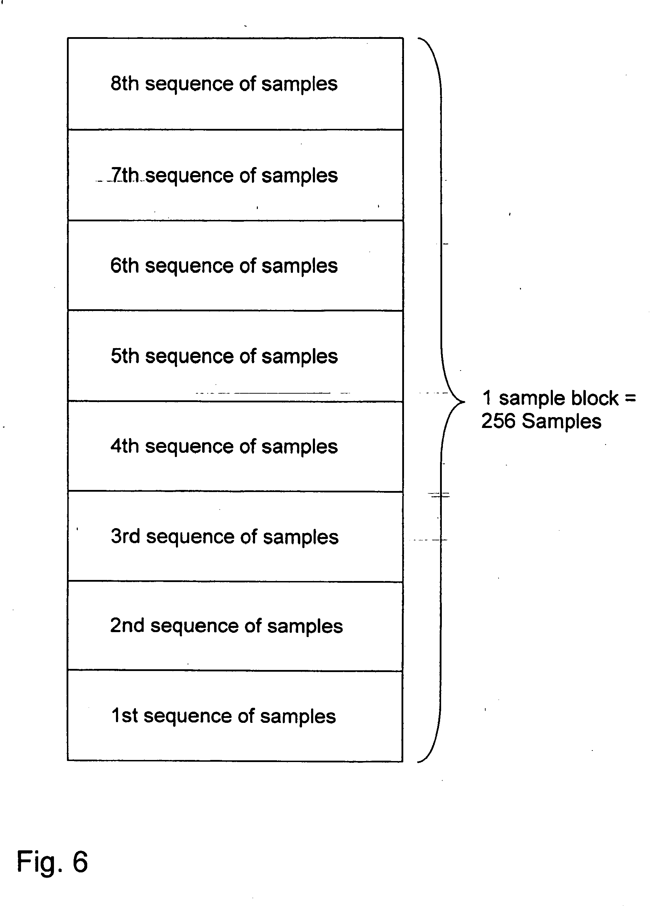

Like in the first embodiment it is assumed that the parameter adaptor 16C operates on 256 data points. This means that each sample block would have a predefined sample block size of 256 samples. In the second embodiment, each sample block to be stored in the block memory 16E is divided into sample bins as depicted in Fig. 6. In the configuration depicted in Fig. 6, the sample block consists of 8 sample bins. The sample bins are configured to store one sample sequence each, each sample sequence comprising 16 consecutive samples captured from the second sample stream.

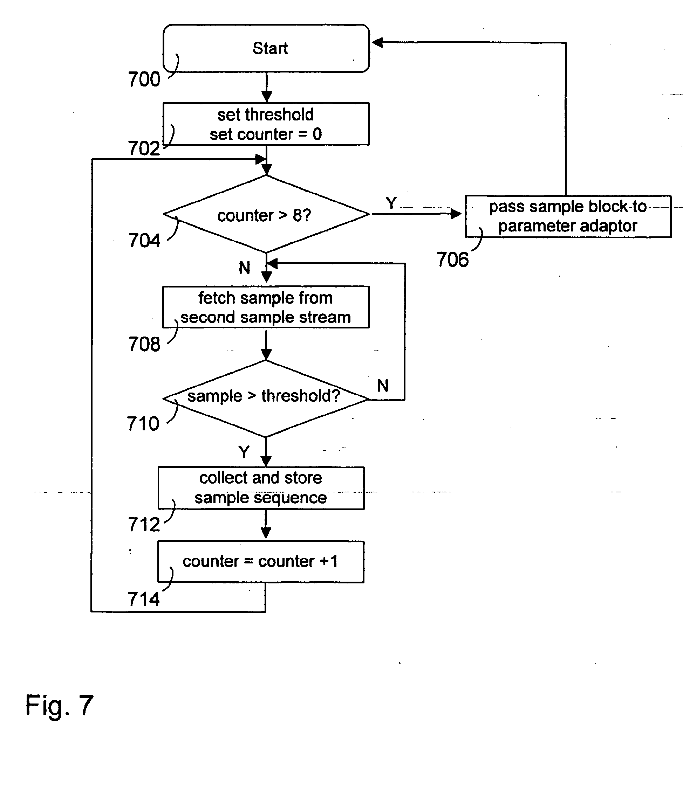

In the following, three variants of selective collection mechanisms according to the second embodiment of the invention will be described with reference to the flow charts depicted in Figs. 7 to 9. The three collection mechanisms comprise the common feature of collecting a plurality of sample sequences, each collected sample sequence capturing, if possible, one signal peak detected by way of a threshold decision. Of course, other detection mechanisms like the implementation of gradient analysis to identify relative maxima could be used as well.

The selection mechanism depicted in Fig. 7 is based on a fixed threshold value that is set in a first step 702. Additionally, a counter which counts the number of collected sample sequences already collected in the current sample block is set to zero. In a second step 704, the assessment unit 16D determines whether the sample block is already full, i.e., if enough sample sequences to enable the parameter adaptor 16C to create an updated set of adapted predistortion data have been collected. In the case of the sample block depicted in Fig. 6 this means that the assessment unit 16D determines whether or not 8 sample sequences have already been stored in block memory 16E. If 8 sample sequences have been collected, the method continues with step 706. In step 706 the sample block stored in the block memory 16E is passed to the parameter adaptor 16C which immediately starts to create adapted predistortion data as described above. From step 706 the method loops back to the start 700.

In the case the assessment unit 16D determines in step 704 that one or more sample bins are still empty, the method continuous with step 708. In step 708 the assessment unit 16D fetches a new sample from the second sample stream output by the feedback unit 26. The assessment unit 16D then determines in step 710 whether or not the sample is above the threshold value that has been set in step 702. If the sample is not above that threshold value the method loops back to step 708 where the next sample is fetched from the second sample stream.

On the other hand, if the sample is above the threshold value, the assessment unit 16D collects a sample sequence of 16 consecutive samples comprising that sample which is above the threshold. The collected sample sequence could start with the sample which is above the threshold value or could also comprise one or more samples which were fetched prior to occurrence to the sample lying above that threshold value. In the latter case these prior samples are taken from the delay buffer mentioned above. The sample sequence collected in step 712 is stored by the assessment unit 16D in the block memory 16 E, i.e., in an empty sample bin of the sample block depicted in Fig. 6. In a next step 714, the counter is increased by one. From step 714 the method loops back to step 704 where it is determined anew whether or not 8 sample sequences have already been collected.

The collection mechanism depicted in the flow chart of Fig. 7 is very efficient with respect to processing and storage resources. However, due to variable traffic conditions and different signal statistics it is difficult to predict how long it will take until a sample block is completed. In order to cope with varying traffic situations and changing signal statistics further mechanisms may thus be provided. These further mechanisms preferably comprise at least one of a variable threshold value and a timing control based on one or more timers. In the following, two collection mechanisms implementing both a variable threshold and a dedicated time control are described in more detail.

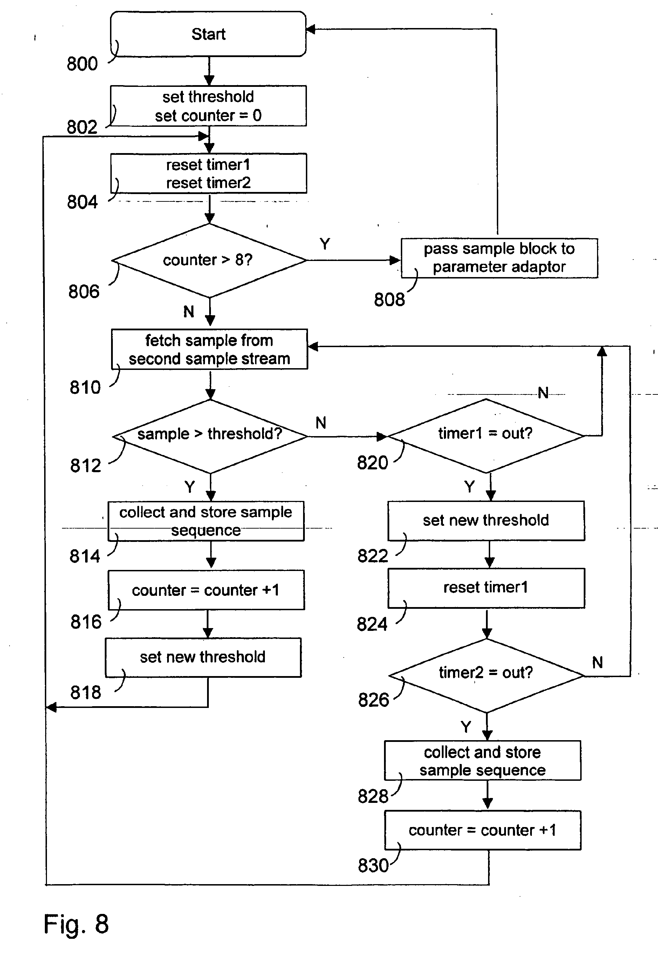

The collection mechanism depicted in Fig. 8 relies on a variable threshold value on the one hand and on two timers on the other hand. In a first step 802, a threshold value and a counter are set as described above in connection with the collection mechanism depicted in Fig. 7. In a second step 804, the two timers are reset. The following steps 806 to 816 are equivalent to the corresponding steps 704 to 714 discussed above in context with the collection mechanism of Fig. 7. Additionally, in step 818, the threshold value is updated by setting a new threshold value to a level dependent upon the recently collected sample sequence. For example, the new threshold value may be set to the peak signal level, or a fraction thereof, detected in the recently collected sample sequence. From step 818 the method loops back to step 804 where the two timers are reset.

If the assessment unit 16D determines in step 812 that a currently fetched sample is not above the current threshold value, the method continuous with step 820. In step 820 the first timer is assessed by the assessment unit 16D with respect to a time out. If no time out is detected, the method continuous with step 810 and a subsequent sample is fetched from the second sample stream. On the other hand, if a time out is detected in step 820, i.e., if the signal level does not exceed the current threshold value during a certain period of time, the method continuous with step 822. In step 822 a new threshold value is set by reducing the currently valid threshold value. The threshold reduction in step 822 could be an exponential decay so that the new threshold value is set to the currently threshold value times a constant < 1. After the new threshold value has been set in step 822, the first timer is reset in step 824.

In the following step 826 the assessment unit 16D determines whether or not a time out of the second timer has occurred. The second timer is implemented to be able to keep control of the total time it takes to aquire on sample sequence. It can thus be ensured that the parameter adaptor 16C always receives a new sample block within a predefined time interval. Usually, the second timer keeps track of a longer time interval than the first timer. However, to simplify the collection mechanisms the time intervals monitored by the first and the second timer, respectively, could be the same.

If the assessment unit 16D does not determine a time out in step 826, the method continuous with step 810 and the next sample is fetched from the second sample stream. Otherwise, i.e., if a time out of the second timer is determined, the method continuous with step 828. In step 828 a sample sequence of 16 consecutive samples is collected and stored regardless of the fact whether or not the collected samples satisfy the currently valid threshold condition. Then, the counter is increased by one in step 830 and the method loops back to step 804.

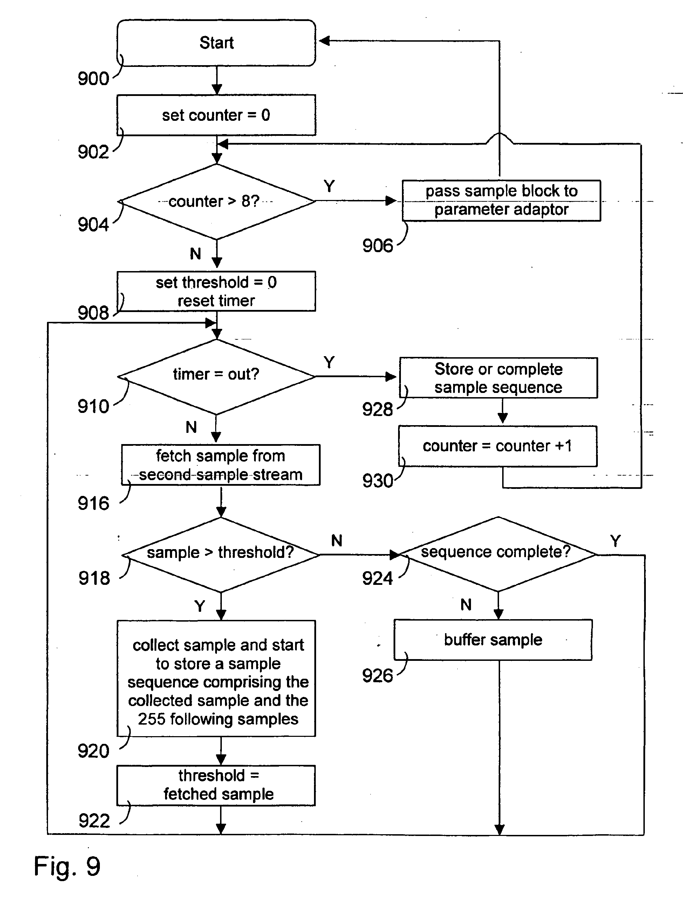

Another variant of the collection mechanism according to the second embodiment of the invention is depicted in the flow chart of Fig. 9. This collection mechanism is designed to collect and store sample sequences containing the largest peak occurring during a predefined time out period.

Steps 902 to 906 basically correspond to steps 702 to 706 described above in connection with the collection mechanism of Fig. 7. The only difference is the fact that the threshold value is set only after the assessment unit 16D has determined in step 904 that the number of previously collected sample sequences is less than 8. Then, the threshold is set to 0 in step 908. Moreover, a timer is reset in step 908.

In the next step 910 the assessment unit 16D determines whether or not a time out of the timer has occurred. If a time out is actually detected, the method continuous with step 928. In step 928 a temporarily buffered sample sequence, which has been acquired as will be discussed below in more detail, is stored permanently in a sample bin of a sample block, i.e., in the block memory 16E. If necessary, i.e., if the buffered sample sequence does not comprise 16 samples yet, the incomplete sample sequence is completed prior to storing. From step 928 the method continuous with step 930. In step 930 the counter is increased by one. The method then loops back to step 904 to determine whether or not 8 sample sequences have already been collected.

If the assessment unit 16D does not detect a time out in step 910, the method continuous with step 916 and a new sample is fetched from the second sample stream output by the feedback unit 26. The newly fetched sample is then subjected to a threshold decision in step 918. In step 918 the assessment unit 16D determines whether or not the newly fetched sample lies above the currently valid threshold value. If this is the case, this sample is collected and temporarily buffered in step 920. Additionally, preceding and/or following samples are collected to complete a sample sequence of 16 samples. For example, in step 920 the newly fetched sample as well as 7 preceding samples may be buffered. Since 8 samples are still missing to complete a sample sequence of 16 samples, the 8 following samples are collected and buffered as well (steps 918 and 924, see below) subject to the condition that the 8 following samples do not lie above the adapted threshold value which is newly set in the following step 922.

In step 922 the new threshold value is set to e.g. the amplitude value of the sample that was fetched from the second sample stream and that passed the threshold decision of step 918. This corresponds to an increase of the threshold value. From step 922 the method loops back to step 910 where it is determined whether or not a time out has occurred.

If it is determined in step 918 that the newly fetched sample does not lie above the threshold, the method continuous with step 924. In step 924 the assessment unit 16D assesses whether or not the currently buffered sequence is complete, i.e., comprises 16 samples. If the buffered sample sequence is not yet complete, the newly fetched sample is buffered in step 926 and the method loops back to step 910. On the other hand, if the sequence already comprises 16 samples, the method immediately loops back to step 910 without buffering the newly fetched sample.

The three variants of selective collection mechanisms exemplarily described above with reference to Figs. 7 to 9 are based on the collection of eight sample sequences, each sample sequence comprising a specific number of data points. It should be noted that the number of sample sequences and the number of data points per sample sequence are in principle arbitrary and depend only on the processing capabilities of the parameter adaptor 16C.

The selective collection mechanisms depicted in Figs. 5 and 7 to 9 not only improve convergence speed even for complex WCDMA signals, but also lead to a higher out-of-band emission suppression due to increased accuracy. A further advantage is the fact that the performance of the adaptation technique is highly independent from particular modulation data statistics.

Modifications and alternative embodiments of the invention are contemplated which do not depart from the scope of the invention as defined by the appended claims. It is intended that the claims cover all such modifications that fall within their scope.

## Claims

1. A method of performing adaptive predistortion using predistortion data to compensate nonlinearities of an amplifier (22) which produces from an input radio signal generated from a first sample stream an amplified radio signal, comprising:
- generating a second sample stream from the amplified radio signal; the method being **characterised by**:
- selectively collecting samples from the second sample stream such that the statistical properties of the collected samples differ from the average statistical properties of the second sample stream;
- creating adapted predistortion data based on a comparison of the selectively collected samples from the second sample stream with the corresponding samples from the first sample stream; and
- performing predistortion of the first sample stream using the adapted predistortion data to produce a predistorted third sample stream.

2. The method of claim 1,
wherein for each sample comprised within one of the sample streams or in regular intervals it is assessed whether or not a corresponding sample from the second sample stream is to be collected.

3. The method of claim 1 or 2,
wherein samples from at least the second sample stream are selectively collected also during generation of the predistortion data.

4. The method of one of claims 1 to 3,
wherein the statistical properties relate to an amplitude or power probability distribution of the collected samples.

5. The method of claim 4,
wherein the amplitude or power probability distribution of the collected samples is raised at least locally compared to an average amplitude probability distribution of the second sample stream.

6. The method of claim 5,
wherein the amplitude or power probability distribution of the collected samples is raised at least for amplitude or power values of an upper amplitude or power range.

7. The method of claim 5 or 6,
wherein samples from at least the second sample stream are selectively collected such that the amplitude or power probability distribution of the collected samples becomes constant at least for amplitude or power values of an upper amplitude or power range.

8. The method of one of claims 1 to 7,
wherein samples from at least the second sample stream are collected individually.

9. The method of one of claims 1 to 7,
wherein samples from at least the second sample stream are selectively collected in the form of one or more sample sequences.

10. The method of claim 9,
wherein the at least one sample sequence captures one or more signal peaks.

11. The method of claim 10,
wherein the signal peak is identified by a threshold decision.

12. The method of claim 11,
wherein the threshold decision is based on a variable threshold value.

13. The method of claim 12,
wherein a variation of the variable threshold value is controlled in dependence of at least one of time, a previous threshold value and a current signal peak.

14. The method of one of claims 1 to 13,
wherein the samples from the second sample stream are collected in the form of sample blocks.

15. The method of claim 14,
wherein the adapted predistortion data are created on a sample block-by-sample block basis.

16. The method of claim 14 or 15,
wherein each sample block is comprised of one or more sample bins and wherein, if the number of samples collected in a sample block equals or exceeds a predefined sample block size, a sample from the second sample stream is not collected if the sample bin reserved for this sample has reached its nominal bin size, and collected in this sample bin otherwise.

17. The method of claim 16,
wherein, if the sample is collected in the sample bin reserved for this sample, a sample collected in the sample bin which exceeds its nominal bin size most is discarded.

18. A computer program product comprising program code portions for performing the steps of one of claims 1 to 17 when the computer program product is run on a computer.

19. The computer program product of claim 18, stored on a computer readable recording medium.

20. A transmitter stage (10), comprising:
- an amplifier (22) which produces from an input radio signal generated from a first sample stream an amplified radio signal,
- a feedback unit (26) for generating a second sample stream from the amplified radio signal; the transmitter stage being **characterised by**:
- a unit (16D) for selectively collecting samples from the second sample stream such that the statistical properties of the collected samples differ from the average statistical properties of the second sample stream;
- a parameter adaptor (16C) for creating adapted predistortion data based on a comparison of the collected samples from the second sample stream with the corresponding samples from the first sample stream; and
- a data modifier (16A) for performing predistortion of the first sample stream using the adapted predistortion data.

21. The transmitter stage of claim 20, configured to perform the steps of one of claims 1 to 14.

22. A wireless communications system comprising the transmitter stage (10) of claim 20 or 21.

## Patentansprüche

1. Verfahren zum Durchführen einer angepassten Vorverzerrung mittels Vorverzerrungsdaten zum Kompensieren von Nichtlinearitäten eines Verstärkers (22), welcher aus einem eingehenden, aus einem ersten Abtastwertstrom generierten Funksignal ein verstärktes Funksignal erzeugt, umfassend:
- Generieren eines zweiten Abtastwertstroms aus dem verstärkten Funksignal; wobei das Verfahren charakterisiert ist durch:
- selektives Aufnehmen von Abtastwerten aus dem zweiten Abtastwertstrom derart, dass sich die statistischen Eigenschaften der aufgenommenen Abtastwerte von den durchschnittlichen statistischen Eigenschaften des zweiten Abtastwertstroms unterscheiden;
- Erstellen angepasster Vorverzerrungsdaten basierend auf einem Vergleich der selektiv aus dem zweiten Abtastwertstrom aufgenommenen Abtastwerte mit den korrespondierenden Abtastwerten aus dem ersten Abtastwertstrom; und
- Durchführen einer Vorverzerrung des ersten Abtastwertstroms mittels der angepassten Vorverzerrungsdaten, um einen vorverzerrten dritten Abtastwertstrom zu erzeugen.

2. Verfahren nach Anspruch 1, wobei für jeden von einem der Abtastwertströme umfassten Abtastwert oder in regelmäßigen Abständen beurteilt wird, ob ein korrespondierender Abtastwert aus dem zweiten Abtastwertstrom aufgenommen wird oder nicht.

3. Verfahren nach Anspruch 1 oder 2, wobei Abtastwerte aus wenigstens dem zweiten Abtastwertstrom auch während des Generierens der Vorverzerrungsdaten selektiv aufgenommen werden.

4. Verfahren nach einem der Ansprüche 1 bis 3, wobei sich die statistischen Eigenschaften auf eine Amplituden- oder Leistungs-Wahrscheinlichkeitsverteilung der aufgenommenen Abtastwerte bezieht.

5. Verfahren nach Anspruch 4, wobei die Amplituden- oder Leistungs-Wahrscheinlichkeitsverteilung der aufgenommenen Abtastwerte wenigstens lokal gegenüber einer durchschnittlichen Amplituden-Wahrscheinlichkeitsverteilung des zweiten Abtastwertstroms erhöht ist.

6. Verfahren nach Anspruch 5, wobei die Amplituden- oder Leistungs-Wahrscheinlichkeitsverteilung der aufgenommenen Abtastwerte wenigstens für Amplituden- oder Leistungswerte eines oberen Amplituden- oder Leistungsbereichs erhöht ist.

7. Verfahren nach Anspruch 5 oder 6, wobei Abtastwerte aus wenigstens dem zweiten Abtastwertstrom selektiv derart aufgenommen werden, dass die Amplituden- oder Leistungs-Wahrscheinlichkeitsverteilung der aufgenommenen Abtastwerte wenigstens für Amplituden- oder Leistungswerte eines oberen Amplituden- oder Leistungsbereichs konstant ist.

8. Verfahren nach einem der Ansprüche 1 bis 7, wobei Abtastwerte aus wenigstens dem zweiten Abtastwertstrom einzeln aufgenommen werden.

9. Verfahren nach einem der Ansprüche 1 bis 7, wobei Abtastwerte aus wenigstens dem zweiten Abtastwertstrom selektiv in Form einer oder mehrerer Abtastwertsequenzen aufgenommen werden.

10. Verfahren nach Anspruch 9, wobei die wenigstens eine Abtastwertsequenz eine oder mehrere Signalspitzen erfasst.

11. Verfahren nach Anspruch 10, wobei die Signalspitze durch eine Schwellenwert-Entscheidung identifiziert wird.

12. Verfahren nach Anspruch 11, wobei die Schwellenwert-Entscheidung auf einem veränderlichen Schwellenwert basiert.

13. Verfahren nach Anspruch 12, wobei eine Änderung des veränderlichen Schwellenwerts in Abhängigkeit von wenigstens einem von Zeit, einem früheren Schwellenwert und einer gegenwärtigen Signalspitze gesteuert wird.

14. Verfahren nach einem der Ansprüche 1 bis 13, wobei die Abtastwerte aus dem zweiten Abtastwertstrom in Form von Abtastwerte-Blöcken aufgenommen werden.

15. Verfahren nach Anspruch 14, wobei die angepassten Vorverzerrungsdaten Abtastwerte-Block-weise erstellt werden.

16. Verfahren nach Anspruch 14 oder 15, wobei jeder Abtastwerte-Block einen oder mehrere Abtastwerte-Körbe umfasst und wobei, falls die Anzahl von in einem Abtastwerte-Block aufgenommenen Abtastwerten gleich oder größer einer voreingestellten Abtastwerte-Blockgröße ist, ein Abtastwert aus dem zweiten Abtastwertstrom nicht aufgenommen wird, falls der für diesen Abtastwert reservierte Korb seine nominale Korbgröße erreicht hat, und andernfalls in diesem Abtastwerte-Korb aufgenommen wird.

17. Verfahren nach Anspruch 16, wobei, falls der Abtastwert in dem für diesen Abtastwert reservierten Abtastwerte-Korb aufgenommen wird, ein Abtastwert, der in dem Abtastwerte-Korb, der seine nominale Korbgröße am weitesten übersteigt, aufgenommen ist, verworfen wird.

18. Computerprogrammprodukt umfassend Programmcodeteile zur Durchführung der Schritte eines der Ansprüche 1 bis 17, wenn das Computerprogrammprodukt auf einem Computer läuft.

19. Computerprogrammprodukt nach Anspruch 18, das auf einem computerlesbaren Aufzeichnungsmedium gespeichert ist.

20. Sendestufe (10), umfassend:
- einen Verstärker (22), der aus einem eingehenden, aus einem ersten Abtastwertstrom generierten Funksignal ein verstärktes Funksignal erzeugt,
- eine Rückkopplungseinheit (26) zur Erzeugung eines zweiten Abtastwertstroms aus dem verstärkten Funksignal; wobei die Sendestufe **gekennzeichnet ist durch**:
- eine Einheit (16D) zum selektiven Aufnehmen von Abtastwerten aus dem zweiten Abtastwertstrom derart, dass sich die statistischen Eigenschaften der aufgenommenen Abtastwerte von den durchschnittlichen statistischen Eigenschaften des zweiten Abtastwertstroms unterscheiden;
- einen Parameter-Anpasser (16C) zum Erstellen von angepassten Vorverzerrungsdaten basierend auf einem Vergleich der aufgenommenen Abtastwerte aus dem zweiten Abtastwertstrom mit den korrespondierenden Abtastwerten aus dem ersten Abtastwertstrom; und
- einen Daten-Modifizierer (16A) zur Durchführung einer Vorverzerrung des ersten Abtastwertstroms mittels der angepassten Vorverzerrungsdaten.

21. Sendestufe nach Anspruch 20, ausgebildet zur Durchführung der Schritte eines der Ansprüche 1 bis 14.

22. Drahtloses Kommunikationssystem umfassend die Sendestufe (10) des Anspruchs 20 oder 21.

## Revendications

1. Procédé d'exécution d'une distorsion préalable adaptative utilisant des données de distorsion préalable pour compenser les non-linéarités d'un amplificateur (22) qui produit à partir d'un signal radio d'entrée généré depuis un premier flux d'échantillons un signal radio amplifié, comprenant :
- la génération d'un deuxième flux d'échantillons à partir du signal radio amplifié ; le procédé étant **caractérisé par** :
- la collecte d'échantillons de manière sélective à partir du deuxième flux d'échantillons de telle sorte que les propriétés statistiques des échantillons collectés diffèrent des propriétés statistiques moyennes du deuxième flux d'échantillons ;
- la création de données de distorsion préalable adaptées sur la base d'une comparaison des échantillons collectés de manière sélective à partir du deuxième flux d'échantillons avec les échantillons correspondants provenant du premier flux d'échantillons ; et
- l'exécution de la distorsion préalable du premier flux d'échantillons utilisant les données de distorsion préalable adaptées pour produire un troisième flux d'échantillons distordu au préalable.

2. Procédé selon la revendication 1,
dans lequel pour chaque échantillon compris dans un des flux d'échantillons ou dans des intervalles réguliers il est évalué si un échantillon correspondant provenant du deuxième flux d'échantillons doit être collecté ou non.

3. Procédé selon la revendication 1 ou 2,
dans lequel les échantillons provenant au moins du deuxième flux d'échantillons sont collectés de manière sélective également pendant la génération des données de distorsion préalable.

4. Procédé selon l'une quelconque des revendications 1 à 3,
dans lequel les propriétés statistiques concernent une distribution d'une probabilité d'amplitude ou de puissance des échantillons collectés.

5. Procédé selon la revendication 4,
dans lequel la distribution d'une probabilité d'amplitude ou de puissance des échantillons collectés est levée au moins localement comparée à une distribution d'une probabilité d'amplitude moyenne du deuxième flux d'échantillons.

6. Procédé selon la revendication 5,
dans lequel la distribution d'une probabilité d'amplitude ou de puissance des échantillons collectés est levée au moins pour des valeurs d'amplitude ou de puissance d'une gamme supérieure d'amplitudes ou de puissances.

7. Procédé selon la revendication 5 ou 6,
dans lequel les échantillons provenant au moins du deuxième flux d'échantillons sont collectés de manière sélective de telle sorte que la distribution d'une probabilité d'amplitude ou de puissance des échantillons collectés devienne constante au moins pour les valeurs d'amplitude ou de puissance d'une gamme supérieure d'amplitudes ou de puissances.

8. Procédé selon l'une quelconque des revendications 1 à 7,
dans lequel les échantillons provenant au moins du deuxième flux d'échantillons sont collectés individuellement.

9. Procédé selon l'une quelconque des revendications 1 à 7,
dans lequel les échantillons provenant au moins du deuxième flux d'échantillons sont collectés de manière sélective sous la forme d'une ou plusieurs séquence(s) d'échantillons.

10. Procédé selon la revendication 9,
dans lequel l'au moins une séquence d'échantillons capture une ou plusieurs crête(s) du signal.

11. Procédé selon la revendication 10,
dans lequel la crête du signal est identifiée par une décision de seuil.

12. Procédé selon la revendication 11,
dans lequel la décision de seuil est basée sur une valeur de seuil variable.

13. Procédé selon la revendication 12,
dans lequel une variation de la valeur de seuil variable est contrôlée sous la dépendance d'au moins un du temps, d'une valeur de seuil précédente et d'une crête du signal actuelle.

14. Procédé selon l'une quelconque des revendications 1 à 13,
dans lequel les échantillons provenant du deuxième flux d'échantillons sont collectés sous la forme de blocs d'échantillons.

15. Procédé selon la revendication 14,
dans lequel les données de distorsion préalable adaptées sont créées sur une base de bloc bloc par échantillon d'échantillons.

16. Procédé selon la revendication 14 ou 15,
dans lequel chaque bloc d'échantillons est composé d'un ou plusieurs fichier(s) d'échantillons et dans lequel, si le nombre d'échantillons collectés dans un bloc d'échantillons égale ou dépasse une taille de bloc d'échantillons prédéfinie, un échantillon provenant du deuxième flux d'échantillons n'est pas collecté si le fichier d'échantillons réservé pour cet échantillon a atteint sa taille de fichier nominal, et collecté dans ce fichier d'échantillons autrement.

17. Procédé selon la revendication 16,
dans lequel, si l'échantillon est collecté dans le fichier d'échantillons réservé pour cet échantillon, un échantillon collecté dans le fichier d'échantillons qui dépasse le plus sa taille de fichier nominal est supprimé.

18. Produit de programme informatique comprenant des parties de code de programme pour exécuter les étapes de l'une quelconque des revendications 1 à 17, lorsque le produit de programme informatique est exécuté sur un ordinateur.

19. Produit de programme informatique selon la revendication 18, stocké sur un support d'enregistrement lisible par ordinateur.

20. Phase de transmission (10), comprenant :
- un amplificateur (22) qui produit à partir d'un signal radio entrant généré depuis un premier flux d'échantillons un signal radio amplifié,
- une unité de contre-réaction (26) pour générer un deuxième flux d'échantillons à partir du signal radio amplifié ; la phase de transmetteur étant **caractérisée par** :
- une unité (16D) pour collecter de manière sélective les échantillons à partir d'un deuxième flux d'échantillons de telle sorte que les propriétés statistiques des échantillons collectés diffèrent des propriétés statistiques moyennes du deuxième flux d'échantillons ;
- un adaptateur de paramètre (16C) pour créer des données de distorsion préalable adaptées sur la base d'une comparaison des échantillons collectés à partir du deuxième flux d'échantillons avec les échantillons correspondants provenant du premier flux d'échantillons ; et
- un modificateur de données (16A) pour réaliser une distorsion préalable du premier flux d'échantillons utilisant les données de distorsion préalable adaptées.

21. Phase de transmetteur selon la revendication 20,
configurée pour exécuter les étapes selon l'une quelconque des revendications 1 à 14.

22. Système de communications sans fil comprenant la phase de transmetteur (10) de la revendication 20 ou 21.
